# EUROPEAN PATENT APPLICATION

(11) **EP 4 418 286 A1**
(43) Date of publication of application: **21.08.2024**
(21) Application number: 23157294.2
(22) Date of filing: 17.02.2023
(51) Int. Cl.: H01F 27/12, F15D 1/00

(54) **A COOLING ARRANGEMENT FOR COOLING A TRANSFORMER**

(71) Applicant: Hitachi Energy Ltd, 8050 Zürich (CH)
(72) Inventor: SAND, Ulf, 724 63 Västerås (SE); HOSAIN, Lokman, 724 79 Västerås (SE); SALINAS, Ener, 722 10 Västerås (SE); PRADHAN, Manoj Kumar, 724 76 Västerås (SE)
(74) Representative: Valea AB

(57) **Abstract**

The disclosure relates to a cooling arrangement (1) for cooling a transformer (10) in a transformer tank (12), the cooling arrangement (1) comprises a transformer tank (12), to be at least partially filled with an electrically insulating fluid when in use, a transformer (10) having windings (16), at least one heat exchanger (18), and a fluid discharge device (20) arranged in the transformer tank (12), fluidly connected to the at least one heat exchanger (18), and a pump (22) in fluid communication with the at least one heat exchanger (18) and with the fluid discharge device (20). The fluid discharge device (20) comprises at least one Coand 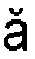 effect fluid flow multiplier (21) configured to discharge the cooled fluid along a discharge axis (c) towards one or more of the windings (16) of the at least one phase leg (14) of the transformer (10).

## Description

### TECHNICAL FIELD

The present disclosure relates to a cooling arrangement for cooling a transformer. In particular, it relates to a cooling arrangement comprising fluid discharge device comprising a fluid flow multiplier towards one or more windings of a transformer.

### BACKGROUND

Transformers may involve high currents, producing heat and therefore, thermal loss as an immediate consequence of thereof. The heat needs to be released to the surroundings for normal operation of transformers.

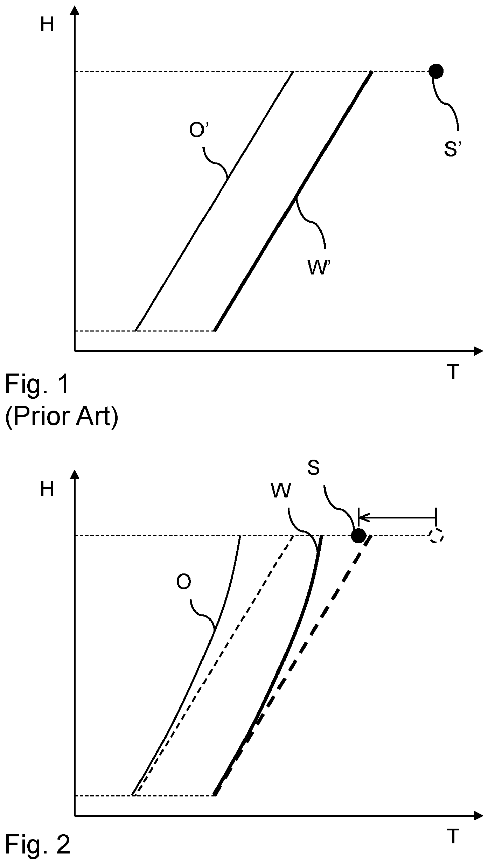

Transformers may be housed in transformer tanks which are filled with electrically insulating fluid, such as oil, in which the transformers are immersed. The insulating fluid may also serve as a cooling medium. Most oil-cooling is carried out by arranging external devices such as heat exchangers, radiators, coolers etc., through which the transformer oil is circulated and cooled. Due to natural convection in the transformer tank, and also in case of forced convection of oil, a temperature profile is set for the oil, which temperature increases from the bottom to the top of the transformer tank and along the transformer windings, as shown in **Fig. 1****.** The oil temperature sets a boundary condition for the winding temperature. Therefore, windings also follow a similar profile from the bottom to the top of the windings. However, there are also some local temperature variations. Windings create radial flux density variations which generates radial eddy current losses, especially at the ends of the windings. Together with relatively hotter fluid at the top of the windings, the radial eddy current losses may lead to hot-spot problems, i.e. locally higher temperature in top parts of the windings.

There is thus a need to alter the temperature profile of the oil such that winding temperature and hotspot temperature may be reduced.

### SUMMARY

Therefore, an object of the disclosure is to provide improved fluid circulation in transformer tanks. In particular, an object of the disclosure is to provide an improved cooling arrangement which circulates fluid, utilizing the Coand 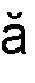 effect, for improved entrainment and inducement of fluid in transformer tanks.

According to a first aspect of the present disclosure, the object is at least partly achieved by a cooling arrangement according to claim 1.

Hence, there is provided a cooling arrangement for cooling a transformer in a transformer tank. The cooling arrangement comprises a transformer tank which is at least partially filled with an electrically insulating fluid when in use. The cooling arrangement further comprises a transformer comprising at least one phase leg, which phase leg has windings coaxially arranged on a coil axis, and the transformer is enclosed in the transformer tank and at least partly immersed in the fluid when in use. At least one heat exchanger external to the transformer tank is comprised in the cooling arrangement. The at least one heat exchanger is in fluid communication with the transformer tank and configured to receive heated fluid from the transformer tank and to supply cooled fluid to the transformer tank. A fluid discharge device is arranged in the transformer tank and is fluidly connected to the at least one heat exchanger to receive cooled fluid from the at least one heat exchanger and to discharge the cooled fluid inside the transformer tank. A pump is in fluid communication with the at least one heat exchanger and with the fluid discharge device and configured to pump cooled fluid from the at least one heat exchanger to the fluid discharge device. The fluid discharge device comprises at least one Coand 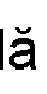 effect fluid flow multiplier configured to discharge the cooled fluid along a discharge axis towards one or more of the windings of the at least one phase leg of the transformer.

A term "air multiplier" is used in prior art and is thus known to the skilled person. Air multipliers are nozzles typically used in bladeless fans. Similarly, in the present disclosure, the term fluid flow multiplier may refer to any type of fluid discharge device/nozzle designed to discharge fluid through an outlet, typically in the form of one or more elongate slits, such that fluid around the discharge device is brought along by the fluid discharged from the outlet. Another term which may be used instead of fluid flow multiplier is Coand 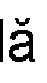 effect fluid flow multiplier. Such fluid discharge devices can vary greatly in design but are often shaped like an extruded hollow profile, although any other suitable shape is possible. The profile usually has an elongate cross-sectional shape, and the outlet is typically configured to discharge fluid in a direction along a longitudinal axis extending along the length of the elongate cross-sectional shape. The profile may have an aerodynamic foil shape. The outlet may be provided anywhere suitable along the length of the cross-sectional shape of the profile, such as at a leading portion of the profile (facing incoming ambient fluid), or at a trailing portion of the profile, facing in the discharge direction of the fluid flow multiplier, or somewhere between the leading and trailing portions of the profile. The profile may be straight but is typically bent to form a ring circumscribing an inner cross-sectional area of the fluid flow multiplier.

The fluid flow multiplier may be provided with a convex wall portion wherein the outlet may be provided such that fluid is discharged adjacent the curved portion, along the curved portion, wherein the discharged fluid `adheres' to the curved wall portion. This leads to increased suction effect acting on ambient fluid on the opposite side of the discharged fluid flow with respect to the curved wall portion.

In the present disclosure, the fluid is primarily an electrically insulating liquid medium such as oil. Hence, terms such as liquid multiplier, or oil multiplier, may be used to refer to the fluid flow multiplier or to the Coand 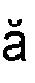 effect fluid flow multiplier. The fluid discharge device may be immersed in the fluid in the transformer tank together with the transformer.

The pump may be fluidly connected to the at least one heat exchanger, either upstream or downstream of the heat exchanger. A plurality of heat exchangers, as well as a plurality of pumps may be comprised in the cooling arrangement. The pump may provide the fluid discharge device with cooled fluid via at least one fluid conduit. The cooled fluid is subsequently discharged along the discharge axis towards the one or more of the windings of the at least one phase leg of the transformer. The fluid cools the windings of the transformer and is in the process heated itself. Due to natural and forced convection, the fluid rises to a top of the transformer tank from which it is supplied to the at least one external heat exchanger. The cooling arrangement is thus a closed system in which a constant volume of fluid circulates.

The transformer has one phase leg per phase. The phase leg may comprise a plurality of windings, such as a high voltage winding, a low voltage winding, and possibly one or more additional windings, such as a tertiary winding. The windings may be coaxially arranged along a coil axis. The coil axis (or coil axes in case of a multi-phase transformer) is often vertically aligned when the transformer is assembled in the transformer tank. However, the coil axis may also be substantially horizontal, such as in the case of traction transformers. The windings of a phase leg may be arranged along a central magnetic limb which, at the ends is inductively and mechanically connected to limbs of any other phase legs via yokes.

Optionally, the fluid discharge device is arranged at a distance from the transformer. The Coand 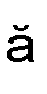 effect is better utilized when the fluid discharge device is arranged at a distance from the transformer, e.g. from the windings of the transformer. Thereby, fluid may more freely be entrained and/or induced by the fluid discharged from the fluid discharge device.

Optionally, each of the at least one fluid flow multiplier forms a loop around the discharge axis, and wherein the at least one loop comprises a fluid outlet configured to expel fluid along the discharge axis.

The loop extends around the discharge axis and may have different shapes, such as circular, elliptical, or polygonal. The loop may be a closed loop around the discharge axis. Alternatively, the loop may be understood to extend at least 90% around the discharge axis. The fluid outlet may be directed along the discharge axis and may extend around at least part of the loop, such as around at least 90% of the loop.

Optionally, the fluid outlet comprises at least one slit extending around the discharge axis. The slit thus extends around at least 90% of the loop. The fluid outlet may alternatively comprise a plurality of openings distributed around the discharge axis along the loop.

Optionally, the loop is configured to entrain fluid surrounding the loop during discharge of fluid.

The loop with the fluid outlet is configured to discharge a jet of fluid along the discharge axis. Fluid moving in the jet causes an underpressure near the jet, on the sides of the jet, such that fluid around the jet is sucked in by the jet and forced to flow along the discharge axis in a phenomenon call entrainment.

Similarly, the jet exiting the fluid outlet around the discharge axis of the loop causes an underpressure radially inside the loop, such that fluid upstream of the loop is sucked through the loop and carried along in the direction of flow, i.e. along the discharge axis, in an entrainment mechanism, also known as inducement.

Optionally, the fluid outlet is arranged to discharge fluid along at least one curved surface of the loop to entrain fluid by the Coand 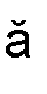 effect along the discharge axis. The curved, or convex, surface may be arranged on a radially inner or outer surface of the loop. When the fluid flow is discharged along the curved surface, the underpressure on the side of the jet facing the curved surface causes the jet to "adhere" to the surface and to follow the curvature of the surface. The curved surface may be configured such that the fluid flows radially away from the discharge axis. Thereby, the pressure radially inside the loop is lowered further, and entrainment/inducement is enhanced.

Optionally, the at least one fluid flow multiplier is coaxially arranged with the windings such that the discharge axis is aligned with the coil axis and such that the fluid discharge device is arranged to discharge fluid along the coil axis towards an end of the windings. Hence, fluid flow along the windings is improved.

Optionally, adjacent coaxially arranged windings of the at least one phase leg are separated from each other by at least one gap and wherein the loop of the at least one fluid flow multiplier is aligned with the at least one gap to inject fluid into the gap during discharge of fluid.

The gap between the windings thus extends coaxially with the windings along the coil axis. When the at least one loop of the fluid flow multiplier is aligned with the gap between coaxial windings that are adjacent to each other, the fluid flow is directed into the gap. Fluid flow between the windings is thereby improved.

Optionally, the windings of the at least one phase leg comprise a plurality of gaps and wherein the fluid discharge device comprises a plurality of fluid flow multipliers, each comprising a loop around the discharge axis, each fluid flow multiplier aligned with a respective coaxial gap to inject fluid into the gap during discharge of fluid.

Thereby, when multiple coaxial windings comprise a gap between each two coaxially adjacent windings, the fluid discharge device may comprise a fluid flow multiplier/loop for each respective gap, thereby discharging a flow of fluid into each gap.

Optionally, the transformer tank, during use, has a tank bottom, and wherein the transformer is arranged vertically above the tank bottom, and wherein the fluid discharge device is arranged to entrain fluid from the tank bottom during discharge of fluid.

In transformer tanks comprising conventional cooling arrangements, cool fluid may collect at the bottom of the transformer tank due to relatively higher density than warmer fluid. Conventional cooling arrangements may have difficulties to circulate the cool fluid. Due to the entrainment of fluid around the fluid discharge device comprising a Coand 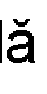 effect fluid flow multiplier according to the present disclosure, the cool fluid at the bottom of the tank may be entrained by a fluid flow multiplier which is arranged near the bottom of the tank. Thereby, efficiency of the cooling arrangement is improved in that cool fluid is utilized to a greater degree.

Optionally, the transformer comprises a plurality of phase legs and the cooling arrangement comprises a plurality of fluid discharge devices and wherein the discharge axis of each fluid discharge device is aligned with the respective coil axis of each phase leg such that each fluid discharge device is arranged to discharge the cooled fluid towards the windings of the respective phase leg of the transformer.

Accordingly, each phase leg may be provided with a fluid discharge device. Each fluid discharge device may, as described above, comprise at least one Coand 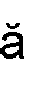 effect fluid flow multiplier.

Optionally, a fluid conduit is arranged to provide an individually predetermined fluid flow from the outlet of the loop of the at least one fluid flow multiplier.

Depending on the arrangement and the configuration of the at least one fluid flow multiplier of the fluid discharge device, a fluid flow multiplier may be provided with a fluid conduit, which fluid conduit may be configured to provide a certain fluid flow to the fluid flow multiplier, which consequently results in a predetermined fluid flow from the outlet of the fluid flow multiplier. In case of a plurality of fluid flow multiplier, each fluid flow multiplier may have a fluid conduit which is arranged to provide an individually predetermined fluid flow from the outlet of each of the respective fluid flow multipliers. Thereby, the discharge of fluid towards the windings, and/or into any gaps between the windings, may be configured and adapted to optimize reduction of temperature along the winding and to reduce hotspot temperature.

Optionally, the fluid conduit is dimensioned to provide a predetermined fluid flow from the loop to which the fluid conduit is fluidly connected.

The individually predetermined fluid flow may thus be set by the dimensions of the fluid conduit. In case of a plurality of fluid flow multipliers, fluid conduits to the respective fluid flow multiplier may be dimensioned to provide the predetermined fluid flow from the fluid flow multiplier in question. Each fluid flow may be determined for a particular location and purpose of a respective fluid flow multiplier.

Optionally, the cooling arrangement further comprises a control unit connected to a valve, and wherein the control unit is configured to control the controllable valve to provide a predetermined fluid flow from the outlet of the loop of the at least one fluid flow multiplier.

By the control unit and the controllable valve, there is provided a possibility of adjusting the fluid flow from each of the at least one loop/fluid flow multiplier during operation of the transformer. The controllable valve(s) may be connected to the fluid conduits outside the transformer tank to avoid interference with electromagnetic fields inside the tank during operation of the transformer.

Optionally, the at least one phase leg is provided with at least one temperature sensor communicatively connected to the control unit, and wherein the predetermined fluid flow is set in dependence of a temperature measurement of the at least one temperature sensor.

At least one temperature sensor, and preferably a plurality of temperature sensors, may be provided on the at least one phase leg. Any temperature sensors may be arranged on the windings of the phase leg. A plurality of temperature sensors may be distributed along an axial length, and/or along a circumference of each winding of the phase leg. Thereby, a temperature profile of each winding may be monitored and the fluid flow from each fluid flow multiplier may be adjusted via the controllable valves to optimize fluid flow in accordance with the respective temperature profile.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Further objects and advantages of, and features of the disclosure will be apparent from the following description of one or more embodiments, with reference to the appended drawings, where:
- Fig. 1: shows examples of temperatures in prior art transformer arrangements.
- Fig .2: shows examples of temperatures in a transformer arrangement comprising a cooling arrangement according to a first aspect of the present disclosure.
- Fig. 3: shows a schematic example of a configuration of a cooling arrangement according to the first aspect of the disclosure.
- Fig. 4: shows another schematic example of a configuration of a cooling arrangement according to the first aspect of the disclosure.
- Fig. 5: shows a top-down view of a fluid discharge device of the first aspect of the present disclosure.
- Fig. 6: shows a cross-sectional side view of the fluid discharge device of Fig. 5.
- Fig. 7: shows a cross-sectional side view of the fluid discharge device of Fig. 5.
- Fig. 8: shows an exemplary arrangement of the fluid discharge device with a phase leg of a transformer.
- Fig. 9: shows an exemplary arrangement of a fluid discharge device comprising two fluid flow multipliers.
- Fig. 10: shows an exemplary arrangement of multiple phase legs, each arranged with a fluid discharge device.
- Fig. 11: shows an exemplary arrangement of fluid flow multipliers fluidly connected by fluid conduits.
- Fig. 12: shows an exemplary arrangement of fluid flow multipliers fluidly connected by fluid conduits.

### DETAILED DESCRIPTION OF EXAMPLE EMBODIMENTS OF THE INVENTION

The present disclosure is developed in more detail below referring to the appended drawings which show examples of embodiments. The disclosure should not be viewed as limited to the described examples of embodiments. Like numbers refer to like elements throughout the description.

The terminology used herein is for the purpose of describing particular aspects of the disclosure only and is not intended to limit the invention. As used herein, the singular forms "a", "an" and "the" are intended to include the plural forms as well, unless the context clearly indicates otherwise. Unless otherwise defined, all terms (including technical and scientific terms) used herein have the same meaning as commonly understood by one of ordinary skill in the art to which this disclosure belongs.

As discussed in the Background section above, transformers may be housed in transformer tanks which are filled with electrically insulating fluid, such as oil, in which the transformers are immersed. The insulating fluid may also serve as a cooling medium. Most cooling is carried out by arranging external devices such as heat exchangers, radiators, coolers etc., through which the fluid is circulated and cooled. Due to natural convection in the transformer tank, and also in case of forced convection of fluid, a temperature profile is set for the oil, which temperature increases from the bottom to the top of the transformer tank and along the transformer windings, as shown in the prior art example of Fig. 1, which illustrates temperatures in prior art transformer arrangements. The diagram illustrates how fluid temperature O', winding temperature W' and hotspot temperature S' may vary with a vertical height H of a prior art transformer arrangement.

**Fig. 2** illustrates a comparison of the prior art transformer arrangement with a cooling arrangement 1 according to a first aspect of the present disclosure. The dashed lines indicate the temperatures in the prior art transformer arrangement. It is shown how the cooling arrangement 1 of the present disclosure significantly lowers the fluid temperature O and the winding temperature W, especially at vertically higher parts of transformer arrangement. Hotspot temperature S is also shown to be lowered. The diagram assumes vertically aligned windings, but the cooling arrangement 1 of the present disclosure is also applicable to traction transformers, having substantially horizontally aligned windings.

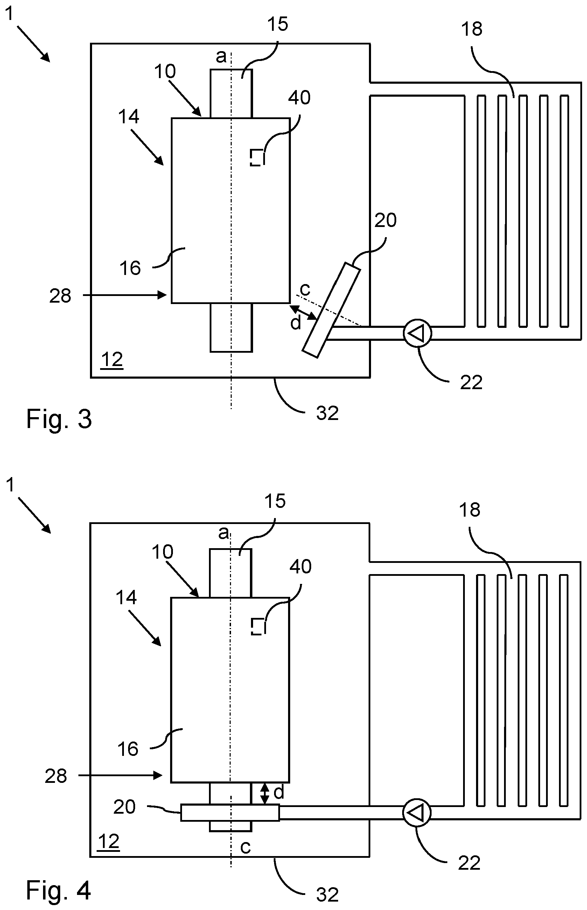

**Fig. 3** shows an example of the cooling arrangement 1 for cooling a transformer 10 in a transformer tank 12. The cooling arrangement 1 comprises a transformer tank 12, which is at least partially filled with an electrically insulating fluid when in use. The insulating fluid may an oil, such as mineral oil. A transformer 10 comprises at least one phase leg 14, which phase leg 14 has windings 16 coaxially arranged on a coil axis a, along a limb 15. Obviously, the transformer 10 is supported on a floor of the transformer tank 12. However, for the sake of simplicity of the drawing, any supporting structure of the transformer 10 has been excluded. The transformer 10 is enclosed in the transformer tank 12 and is at least partly immersed in the fluid. The cooling arrangement 1 further comprises at least one heat exchanger 18 external to the transformer tank 12. The at least one heat exchanger 18 is in fluid communication with the transformer tank 12 and is configured to receive heated fluid from the transformer tank 12 and to supply cooled fluid to the transformer tank 12. A fluid discharge device 20 is arranged in the transformer tank 12, fluidly connected to the at least one heat exchanger 18 to receive cooled fluid from the at least one heat exchanger 18 and to discharge the cooled fluid inside the transformer tank 12. A pump 22 is in fluid communication with the at least one heat exchanger 18 and with the fluid discharge device 20 and is configured to pump cooled fluid from the at least one heat exchanger 18 to the fluid discharge device 20. The fluid discharge device 20 comprises at least one Coand 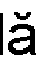 effect fluid flow multiplier 21 configured to discharge the cooled fluid along a discharge axis c towards one or more of the windings 16 of the at least one phase leg 14 of the transformer 10.

In order to better utilize the Coand 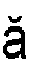 effect, the fluid discharge device 20 may be arranged at a distance d from the transformer 10, e.g. from the windings 16 of the transformer 10. Thereby, fluid may more freely be entrained and/or induced by the fluid discharge from the fluid discharge device. The distance d may be predetermined and may depend on transformer dimensions, space restrictions, etc.

**Fig. 4** illustrates an alternative advantageous configuration of the cooling arrangement 1 shown in **Fig.3****,** where the fluid flow multiplier 21 of the fluid discharge device 20 is coaxially arranged with the windings 16 such that the discharge axis c is aligned with the coil axis a and such that the fluid discharge device 20 is arranged to discharge fluid along the coil axis a towards an end 28 of the windings 16. Thereby, fluid flow along the windings is improved.

The pump 22 may be fluidly connected to the at least one heat exchanger 18, either upstream or downstream of the heat exchanger. In **Fig. 3** and **Fig. 4****,** the pump 22 is shown downstream of the heat exchanger 18. A plurality of heat exchangers 18, as well as a plurality of pumps 22 may be comprised in the cooling arrangement 1. The pump 22 may provide the fluid discharge device 20 with cooled fluid via at least one fluid conduit 34. The cooled fluid is subsequently discharged along the discharge axis c towards one or more of the windings 16 of the at least one phase leg 14 of the transformer 10. The fluid cools the windings 16 of the transformer and absorbs heat in the process. Due to natural and forced convection, the fluid rises to a top of the transformer tank 12 from which it is supplied to the at least one external heat exchanger 18. The cooling arrangement 1 is a closed system in which a constant volume of fluid circulates.

The transformer 10 has one phase leg 14 per phase. The phase leg 14 may comprise a plurality of windings 16, such as a high voltage winding, a low voltage winding, and possibly one or more additional windings, such as a tertiary winding. The windings 16 may be coaxially arranged along the coil axis a. The coil axis a (or coil axes in case of a multi-phase transformer) is often vertically aligned during use, when the transformer 10 is mounted in the transformer tank 12. However, the coil axis a may also be substantially horizontal, such as in the case of traction transformers. The windings 16 of a phase leg 14 may be arranged along a central magnetic limb which, at the ends is inductively and mechanically connected to limbs of any other phase legs via yokes (not shown).

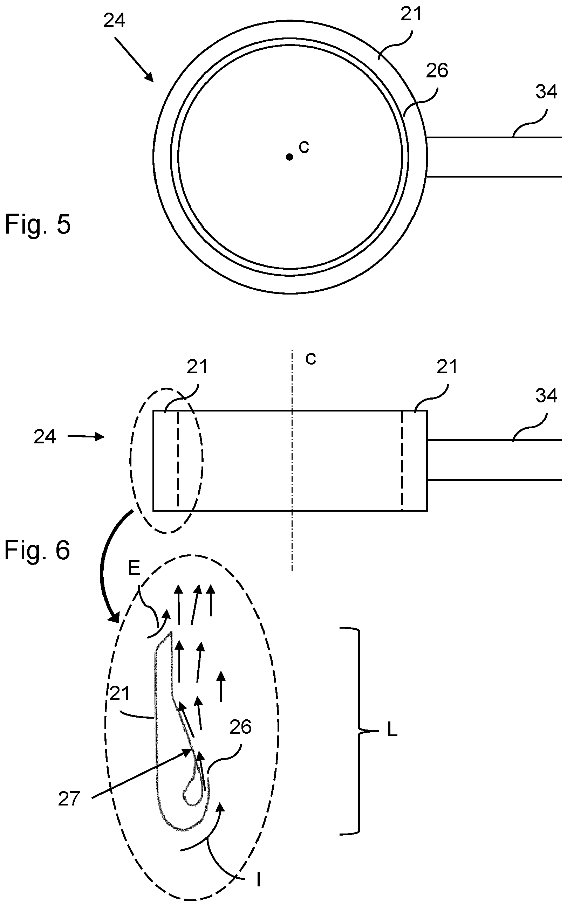

**Figs 5-7** illustrate properties of a fluid flow multiplier 21. As discussed in the Summary section, the term "air multiplier" is used in prior art and is known to the skilled person. Air multipliers are nozzles typically used in bladeless fans. Similarly, in the present disclosure, the term "fluid flow multiplier" may refer to any type of fluid discharge device 20, or nozzle, designed to discharge fluid through an outlet 26, typically in the form of one or more elongate slits, such that fluid surrounding the fluid discharge device 20 is brought along by the fluid discharged from the outlet. Another term which may be used instead of fluid flow multiplier is Coand 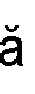 effect fluid flow multiplier 21.

In the present disclosure, the fluid is primarily an electrically insulating liquid medium such as oil. Hence, terms such as liquid multiplier, or oil multiplier, may be used to refer to the fluid flow multiplier 21 or to the Coand 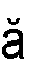 effect fluid flow multiplier 21. The fluid discharge device 20 may be immersed in the fluid in the transformer tank 12 together with the transformer 10.

**Fig. 5** shows a fluid discharge device 20 according to the present disclosure, comprising a fluid flow multiplier 21 in the form of a loop 24 around the discharge axis c, and wherein the at least one loop 24 comprises a fluid outlet 26 configured to expel fluid along the discharge axis c. The fluid outlet 26 may comprise at least one slit 26 extending around the discharge axis c. The loop 24 may have different shapes, such as circular, elliptical, or polygonal, where a circular closed loop 24 is depicted in **Fig. 5****.** The fluid outlet 26 may be directed to discharge fluid along the discharge axis c and may extend around at least part of the loop 24, such as around at least 90% of the loop. The slit exemplified in **Fig. 5** may thus extend around at least 90% of the loop. The fluid outlet 26 may alternatively comprise a plurality of openings distributed around the discharge axis c along the loop 24. At least one fluid conduit 34 may be arranged to fluidly connect the pump 22 to the fluid flow multiplier 21.

**Fig. 6** shows a cross-sectional side view of the loop 24 of **Fig. 5****.** Fluid discharge devices 20 comprising fluid flow multipliers 21 in accordance with the present disclosure may vary greatly in design but are often shaped like an extruded hollow profile, an example of which is shown in the detail of **Fig. 6****,** although any other suitable shape is possible. The profile usually has an elongate cross-sectional shape, and the outlet 26 is typically configured to discharge fluid in a direction along a longitudinal axis, such as the discharge axis c, extending along a length L of the elongate cross-sectional shape, as shown in **Fig. 5****.** The profile may have an aerodynamic foil shape. The outlet 26 may be provided anywhere suitable along the length L of the cross-sectional shape of the profile, such as at a leading portion of the profile, or at a trailing portion of the profile, facing in the discharge direction of the fluid flow multiplier, or somewhere between the leading and trailing portions of the profile. The profile may be straight but is typically bent to form a ring or loop 24 circumscribing an inner cross-sectional area of the fluid flow multiplier 21.

The loop 24 may be configured to entrain fluid surrounding the loop 24 during discharge of fluid. To this end, the loop 24, comprising the fluid outlet 26, may be configured to discharge a jet of fluid along the discharge axis c. Fluid moving in the jet causes an underpressure, or suction effect, near the jet, on the sides of the jet, such that fluid around the jet is sucked in by the jet and forced to flow along the discharge axis in a phenomenon call entrainment, symbolically illustrated by the arrow E. The jet is symbolized by a plurality of arrows along a radially inner circumferential wall portion of the loop 24.

The jet exiting the fluid outlet around the discharge axis c of the loop 24 causes an underpressure radially inside the loop 24, such that fluid upstream of the loop is sucked through the loop and carried along in the direction of flow, i.e. along the discharge axis c, in an entrainment mechanism, also called inducement, symbolically shown by the arrow I.

The fluid flow multiplier 21 may be provided with a convex, or curved wall portion 27 wherein the outlet 26 may be provided such that fluid is discharged adjacent the curved wall portion 27, along the curved wall portion 27, wherein the discharged fluid `adheres' to the curved wall portion 27. This leads to increased suction effect acting on ambient fluid on the opposite side of the discharged fluid flow with respect to the curved wall portion, leading to increase inducement I. In **Fig. 6****,** the curved wall portion 27 forms part of the inner circumferential wall portion of the loop 24.

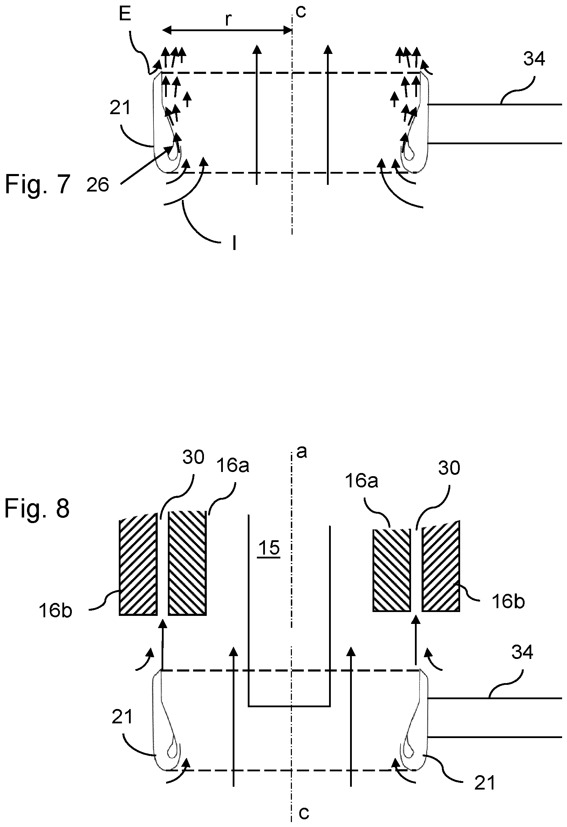

**Fig. 7** is a cross-sectional side view of fluid flow multiplier 21. The arrows illustrate a flow of fluid through the loop 24 resulting from a jet of fluid exiting the fluid outlet 26. The density of arrows or the length of the arrows are not drawn to scale and do not represent the magnitude of the flow. However, due to entrainment E and Inducement I by the jet, the flow of fluid is greatest at a downstream end of the fluid flow multiplier 21. In the example of the loop 24, the flow of fluid is therefore greatest along at a radial distance r from the discharge axis d, which radial distance r corresponds to a radius of the loop 24.

In transformer tanks comprising conventional cooling arrangements, cool fluid may collect at a bottom of the transformer tank due to relatively higher density than warmer fluid. Conventional cooling arrangements may have difficulties to circulate the cool fluid. Due to the entrainment of fluid around the fluid discharge device 20 comprising a Coand 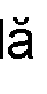 effect fluid flow multiplier 21 according to the present disclosure, the cool fluid at the bottom 32 of the tank 12 may be entrained by a fluid flow multiplier 21 which is arranged near the bottom 32 of the tank 12. Thereby, efficiency of the cooling arrangement 1 is improved in that cool fluid is utilized to a greater degree. Such an arrangement is exemplified in **Fig. 4****.**

**Fig. 8****,** which shows a cross-sectional view of a phase leg 14 of the transformer 10, illustrates how adjacent coaxially arranged windings 16a, 16b of the at least one phase leg 14 may be separated from each other by at least one gap 30 and wherein the loop 24 of the at least one fluid flow multiplier 21 is aligned with the at least one gap 30 to inject fluid into the gap 30 during discharge of fluid. The gap 30 between the windings 16a, 16b thus extends coaxially with the windings 16a, 16b along the coil axis a. When the at least one loop 24 of the fluid flow multiplier 21 is aligned with the gap 30 between coaxial windings 16a, 16b that are adjacent to each other, the fluid flow is directed into the gap 30. Fluid flow between the windings 16a, 16b is thereby improved, reducing temperature of the windings 16a, 16b and mitigating hotspots.

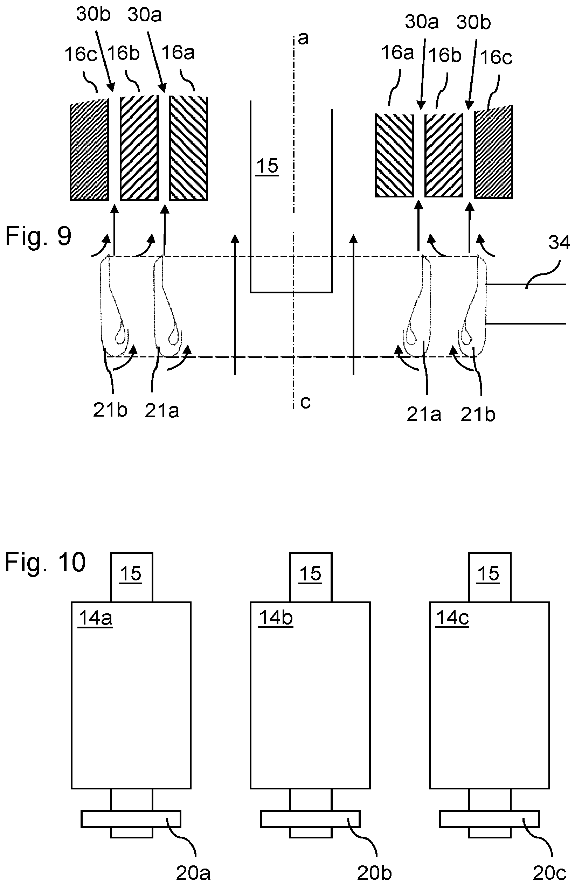

**Fig. 9** shows a plurality of windings 16a, 16b, 16c of a phase leg 14 wherein the windings 16a, 16b, 16c comprise a plurality of gaps 30a, 30b and wherein the fluid discharge device 20 comprises a plurality of fluid flow multipliers 21a, 21b, each comprising a loop 24 around the discharge axis c. Each fluid flow multiplier 21a, 21b may be arranged and aligned with a respective coaxial gap 30a, 30b to inject fluid into the gap 30a, 30b during discharge of fluid. Thereby, when multiple coaxial windings comprise a gap between each two coaxially adjacent windings 16a, 16b, 16c, the fluid discharge device 20 may comprise a fluid flow multiplier 21 for each respective gap 30a 30b, thereby discharging a flow of fluid into each gap 30a, 30b.

In some examples, as illustrated in **Fig. 10****,** the transformer 10 may comprise a plurality of phase legs 14a, 14b, 14c. The cooling arrangement 1 may then comprise a plurality of fluid discharge devices 20a, 20b, 20c. The discharge axis c of each fluid discharge device 20a, 20b, 20c may be aligned with the respective coil axis a of each phase leg 14a, 14b, 14c (as shown in **Fig. 4****)** such that each fluid discharge device 20a, 20b, 20c is arranged to discharge the cooled fluid towards the windings 16 of the respective phase leg 14a, 14b, 14c of the transformer 10. Each phase leg 14a, 14b, 14c may thus be provided with a fluid discharge device 20a, 20b, 20c. Each fluid discharge device 20a, 20b, 20c may, as described above, comprise at least one Coand 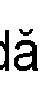 effect fluid flow multiplier 21.

In the cooling arrangement 1, a fluid conduit 34 may be arranged to provide an individually predetermined fluid flow from the outlet 26 of the fluid flow multiplier 21 of the at least one fluid discharge device 20. At least one fluid conduit 34 may fluidly connect each fluid discharge device 20 to the pump 22. Depending on the arrangement and the configuration of the at least one fluid flow multiplier 21 of the fluid discharge device 20, a fluid flow multiplier 21 may be provided with a fluid conduit 34, which fluid conduit 34 may be configured to provide a certain fluid flow to the fluid flow multiplier 21, which consequently results in a predetermined fluid flow from the outlet of the fluid flow multiplier 21. In case of a plurality of fluid flow multipliers 21, each fluid flow multiplier 21 may have a fluid conduit 34 which is arranged to provide an individually predetermined fluid flow from the outlet 26 of each of the respective fluid flow multipliers 21. Thereby, the discharge of fluid towards the windings 16, and/or into any gaps between the windings 16, may be configured and adapted to optimize reduction of temperature along the windings 16 and to reduce hotspot temperature.

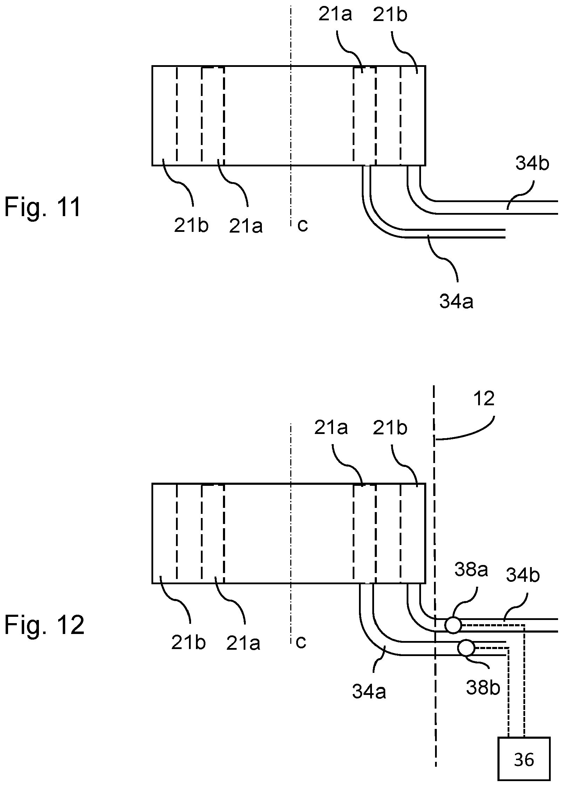

**Fig. 11** illustrates that a fluid conduit 34a, 34b may be dimensioned to provide a predetermined fluid flow from the fluid flow multiplier 21a, 21b to which the fluid conduit 34a, 34b is fluidly connected. As shown, a first fluid conduit 34a provides a more restricted flow of fluid to a first fluid flow multiplier 21a, than a second fluid conduit 34b fluidly connecting a second fluid flow multiplier 21b. The individually predetermined fluid flow of the fluid flow multiplier 21a, 21b may thus be set by the dimensions of the fluid conduit 34a, 34b. In case of a plurality of fluid flow multipliers 21a, 21b, fluid conduits 34a, 34b to the respective fluid flow multiplier 21a, 21b may be dimensioned to provide the predetermined fluid flow from the fluid flow multiplier 21a, 21b in question. The dimensions of each fluid conduit 34a, 34b are determined to adapt the fluid flow to optimize cooling of the windings 16.

As shown in **Fig. 12****,** the cooling arrangement 1 may further comprises a control unit 36 connected to at least one controllable valve 38a, 38b. The control unit 36 may be configured to control the at least one controllable valve 38a, 38b to provide a predetermined fluid flow from the outlet 26 of the fluid flow multiplier 21a, 21b of the at least one fluid discharge device 20. The control unit 36 may comprise a user interface to enable an operator to adjust the at least one controllable valve 38a, 38b.

By the control unit 36 and the controllable valve 38, there is provided a possibility of adjusting the fluid flow from each of the at least one fluid flow multiplier 21a, 21b during operation of the transformer 10. The at least one controllable valve 38a, 38b may be connected to the fluid conduits 34a, 34b outside the transformer tank 12 to avoid interference with electromagnetic fields inside the transformer tank 12 during operation of the transformer 10. A dashed line illustrates a wall of the transformer tank 12 in **Fig. 12****.**

Further, as shown in **Fig. 3** and **Fig. 4****,** the at least one phase leg 14 may be provided with at least one temperature sensor 40 communicatively connected to the control unit 36, and wherein the predetermined fluid flow is set in dependence of a temperature measurement of the at least one temperature sensor 40.

At least one temperature sensor, and preferably a plurality of temperature sensors, may be provided on the at least one phase leg 14. Any temperature sensors may be arranged on the windings 16 of the phase leg 14. A plurality of temperature sensors 40 may be distributed along an axial length, and/or along a circumference of each winding 16 of the phase leg 14. Thereby, a temperature profile of each winding 16 may be monitored and the fluid flow from each fluid flow multiplier 21 may be adjusted via the controllable valves 38 to optimize fluid flow in accordance with the respective temperature profile. In some examples, the control unit 36 may communicate wirelessly with the sensor(s) 40.

## Claims

1. A cooling arrangement (1) for cooling a transformer (10) in a transformer tank (12), the cooling arrangement (1) comprising:
- a transformer tank (12), to be at least partially filled with an electrically insulating fluid when in use,
- a transformer (10) comprising at least one phase leg (14), which phase leg (14) has windings (16) coaxially arranged on a coil axis (a), the transformer (10) being enclosed in the transformer tank (12) and at least partly immersed in the fluid,
- at least one heat exchanger (18) external to the transformer tank (12), the at least one heat exchanger (18) being in fluid communication with the transformer tank (12) and configured to receive heated fluid from the transformer tank (12) and to supply cooled fluid to the transformer tank (12),
- a fluid discharge device (20) arranged in the transformer tank (12) and fluidly connected to the at least one heat exchanger (18) to receive cooled fluid from the at least one heat exchanger (18) and to discharge the cooled fluid inside the transformer tank (12), and
- a pump (22) in fluid communication with the at least one heat exchanger (18) and with the fluid discharge device (20) and configured to pump cooled fluid from the at least one heat exchanger (18) to the fluid discharge device (20),
**characterized in that** the fluid discharge device (20) comprises at least one Coand 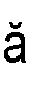 effect fluid flow multiplier (21) configured to discharge the cooled fluid along a discharge axis (c) towards one or more of the windings (16) of the at least one phase leg (14) of the transformer (10).

2. The cooling arrangement (1) of claim 1, wherein the fluid discharge device (20) is arranged at a distance from the transformer (10).

3. The cooling arrangement (1) of claim 1 or 2, wherein each of the at least one fluid flow multiplier (21) forms a loop (24) around the discharge axis (c), and wherein the at least one loop (24) comprises a fluid outlet (26) configured to expel fluid along the discharge axis (c).

4. The cooling arrangement (1) of claim 3, wherein the fluid outlet (26) comprises at least one slit (28) extending around the discharge axis (c).

5. The cooling arrangement (1) of claim 3 or 4, wherein the loop (24) is configured to entrain fluid surrounding the loop (24) during discharge of fluid.

6. The cooling arrangement (1) of any one of claims 3 or 4, wherein the fluid outlet (26) is arranged to discharge fluid along at least one curved wall portion (27) of the loop (24) to entrain fluid by the Coand 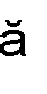 effect along the discharge axis (c).

7. The cooling arrangement (1) of any one of claims 3-6, wherein the at least one fluid flow multiplier is coaxially arranged with the windings (16) such that the discharge axis (c) is aligned with the coil axis (a) and such that the fluid discharge device (20) is arranged to discharge fluid along the coil axis (a) towards an end (28) of the windings (16).

8. The cooling arrangement (1) according to claim 7, wherein adjacent coaxially arranged windings (16a, 16b) of the at least one phase leg (14) are separated from each other by at least one gap (30) and wherein the loop (24) of the at least one fluid flow multiplier (21) is aligned with the at least one gap (30) to inject fluid into the gap (30) during discharge of fluid.

9. The cooling arrangement (1) according to claim 8, wherein the windings (16a, 16b, 16c) of the at least one phase leg (14) comprise a plurality of gaps (30a, 30b) and wherein the fluid discharge device (20) comprises a plurality of fluid flow multipliers (21a, 21b), each comprising a loop (24) around the discharge axis (c), each fluid flow multiplier (21a, 21b) being aligned with a respective coaxial gap (30a, 30b) to inject fluid into the gap (30a, 30b) during discharge of fluid.

10. The cooling arrangement (1) according to any one of claims 3-9, wherein the transformer tank (12), during use, has a tank bottom (32), and wherein the transformer (10) is arranged vertically above the tank bottom (32), and wherein the fluid discharge device (20) is arranged to entrain fluid from the tank bottom (32) during discharge of fluid.

11. The cooling arrangement (1) according to any one of the previous claims, wherein the transformer (10) comprises a plurality of phase legs (14a, 14b, 14c) and the cooling arrangement (1) comprises a plurality of fluid discharge devices (20a, 20b, 20c) and wherein the discharge axis (c) of each fluid discharge device (20a, 20b, 20c) is aligned with the respective coil axis (a) of each phase leg (14a, 14b, 14c) such that each fluid discharge device (20a, 20b, 20c) is arranged to discharge the cooled fluid towards the windings (16) of the respective phase leg (14) of the transformer (10).

12. The cooling arrangement (1) according to any one of claims 7-9, wherein a fluid conduit (34) is arranged to provide an individually predetermined fluid flow from the outlet (26) of the fluid flow multiplier (21) of the at least one fluid flow multiplier (21).

13. The cooling arrangement (1) according to claim 12, wherein the fluid conduit (34) is dimensioned to provide a predetermined fluid flow from the fluid flow multiplier (21) to which the fluid conduit (34) is fluidly connected.

14. The cooling arrangement (1) according to claim 12 further comprising a control unit (36) connected to a controllable valve (38), and wherein the control unit (36) is configured to control the controllable valve (38) to provide a predetermined fluid flow from the outlet (26) of the fluid flow multiplier (21) of the at least one fluid discharge device (20).

15. The cooling arrangement (1) according to claim 14, wherein the at least one phase leg (14) is provided with at least one temperature sensor (40) communicatively connected to the control unit (36), and wherein the predetermined fluid flow is set in dependence of a temperature measurement of the at least one temperature sensor (40).
